# EUROPEAN PATENT APPLICATION

(11) **EP 1 843 475 A1**
(43) Date of publication of application: **10.10.2007**
(21) Application number: 06111864.2
(22) Date of filing: 28.03.2006
(51) Int. Cl.: H03M 13/41

(54) **exploiting known padding data to improve block decode success rate**

(71) Applicant: Research In Motion Limited, Waterloo, Ontario N2L 3W8 (CA)
(72) Inventor: Tran, Phat, Waterloo Ontario N2K 4A7 (CA)
(74) Representative: Rickard, David John

(57) **Abstract**

A method and system of decoding a convolutionally encoded data block having known padding bits. A Viterbi decoder is constrained to a state corresponding to k-1 padding bits immediately adjacent to data bits of the data block, where k is a constraint length of a convolution encoder used to encode the data block. Symbols of the encoded data block that have influence only from the padding bits are discarded.

## Description

This application relates to communications networks in which known padding data are used to rate adapt data to frames/blocks of different sizes, and in particular to methods and systems for exploiting the known padding data to improve decode success rate of convolutionally encoded blocks.

Within the modern network space, it is frequently required to map data from one transmission protocol (or format) to another. For example, within the Enhanced Data for Global Evolution (EDGE) protocol, data can be mapped to/from any of nine different channel coding schemes, depending on the radio link quality. Each coding scheme provides a respective different data throughput (or rate). Consequently, in order to perform a mapping between any two coding schemes, the data must be rate (or size) adapted. In order to do this, padding data are used to match the size of a data block (of the source coding scheme) to the block size of the destination coding scheme.

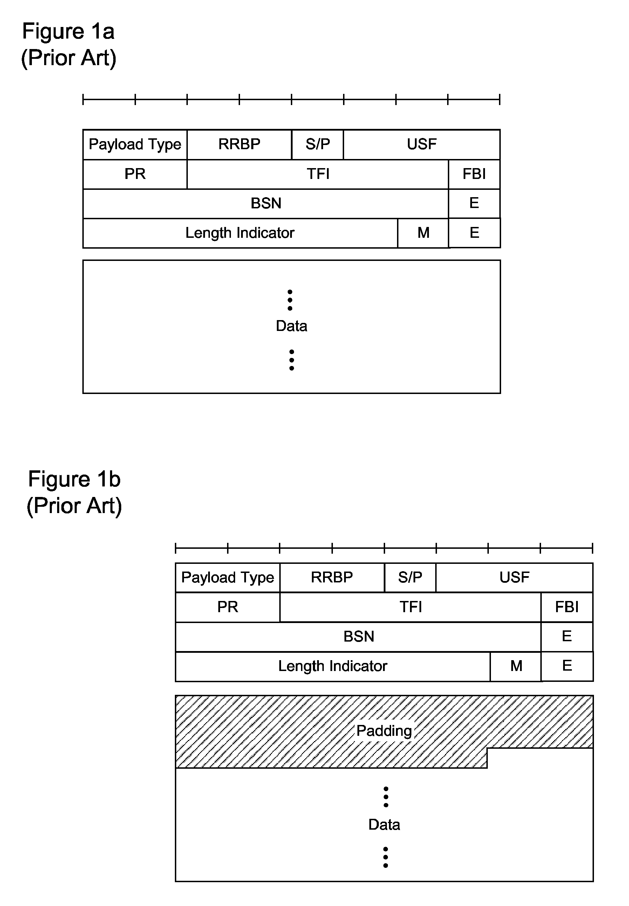

For example, FIGs. 1a and 1b respective show representative data frames of two different channel coding schemes. As may be seen in the figures, both frames include a respective header and a data block. The header block is substantially identical in both channel encoding scheme, but in the scheme of FIG. 1b, the data block is larger, thereby reflecting a higher data rate than the frame of FIG. 1a. With this arrangement, mapping data from the frame of FIG. 1a into that of FIG. 1b requires the insertion of padding bits into the data block of FIG. 1b so as to make up for the difference between the data capacity of the higher rate frame (FIG. 1b) and the lower rate frame (FIG. 1a). In the example of FIG. 1b, the padding bits are prepended to the data. However, the padding bits may equally be appended to the data, or they may be split; with some padding bits being prepended to the data and the remainder appended to the data.

Typically, the padding data is provided as either a data fill of binary 1's or 0's. In all cases, conventional forward error correction (FEC) schemes are unaware of padding bits within a data block. The entire data block will be encoded (e.g. using convolutional encoding) and decoded (e.g. using a Viterbi decoder) without reference to the presence or absence of padding bits within the data block. Since the padding bits are known in advance, this leads to redundant encoding and decoding operations, and increases the probability of errored data decoding.

It would be desirable to enhance forward error correction of encoded data containing known padding bits by exploiting the fact that these padding bits are known and not only need not be decoded, but can also be used to improve the probability of decode success of the data.

According to one aspect of the present application, there is preferably provided: a method of decoding a convolutionally encoded data block having known padding bits, the method comprising steps of: constraining a Viterbi decoder to a state corresponding to k-1 padding bits immediately adjacent data bits of the data block, where k is a constraint length of a convolution encoder used to encode the data block; and discarding symbols of the encoded data block that have influence only from the padding bits.

According to another aspect of the present application, there is preferably provided: a system for decoding a convolutionally encoded data block having known padding bits, the system comprising: a Viterbi decoder; and a controller adapted to: constrain the Viterbi decoder to a state corresponding to k-1 padding bits immediately adjacent data bits of the data block, where k is a constraint length of a convolution encoder used to encode the data block; and discard symbols of the encoded data block that have influence only from the padding bits.

### BRIEF DESCRIPTION OF THE DRAWINGS

Further features and advantages of the present technique will become apparent from the following detailed description, taken in combination with the appended drawings, in which:

Figs. 1a and 1b schematically illustrate a representative EDGE data frame, and an EDGE data frame in which padding bits have been prepended to the data for rate adaptation;

FIG. 2 illustrates a trellis diagram of a conventional viterbi decoder;

FIG. 3 illustrates a trellis diagram of a viterbi decoder in accordance with a first embodiment of the present technique;

FIG. 4 illustrates a trellis diagram of a viterbi decoder in accordance with a second embodiment of the present technique; and

FIG. 5 is a block diagram schematically illustrating a network system.

It will be noted that throughout the appended drawings, like features are identified by like reference numerals.

### DESCRIPTION OF PREFERRED EMBODIMENTS

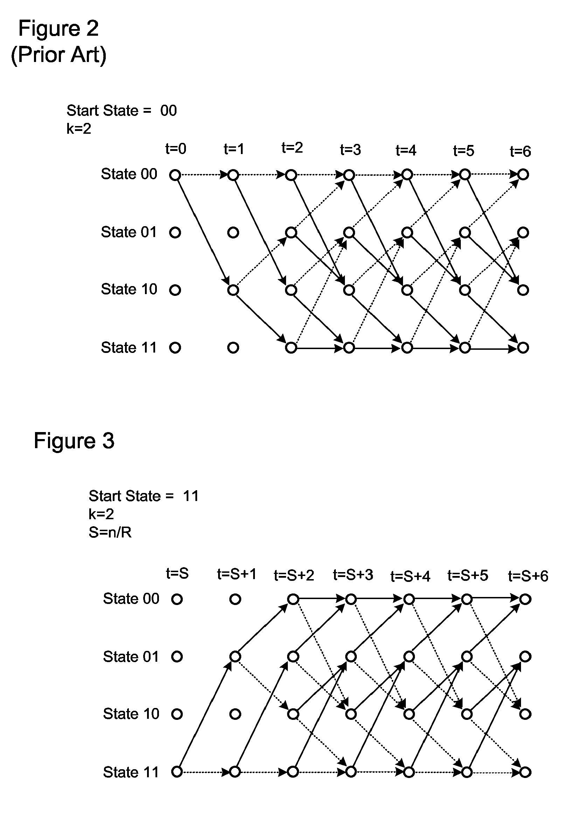

The present disclosure provides methods and apparatus for enhancing forward error correction of convolutionally encoded data containing known padding bits at the beginning and/or at the end of a block. Embodiments are described below, by way of example only, with reference to FIGs. 2-5.

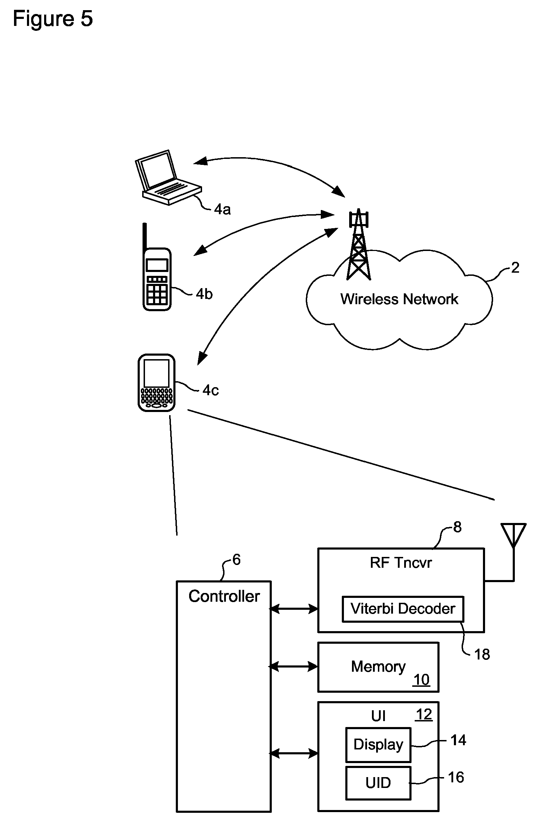

Referring to FIG. 5, a network in which the present technique may be utilised generally comprises a wireless communications network 2 supporting communications with a plurality of subscriber's terminal devices 4 in a manner generally known in the art. In general, the terminal devices 4 can be any of a wide variety of software-controlled wireless devices including, but not limited to mobile telephones, personal computers and PDAs with wireless communication capabilities, self service kiosks and two-way pagers. As may be seen in FIG. 5, such devices 4 generally comprise a controller (such as a microprocessor) 6 connected to an RF transceiver 8 for wireless communications, a memory 10 (at least a portion of which will normally be nonvolatile), and user interface (UI) 12 including a display 14 and one or more user input/output devices (e.g. keyboard, thumb-wheel, stylus, microphone, speaker etc.) 16. Controller 106 will normally control overall operation of mobile station 102 by running operating system software stored in the memory 10. The controller 102 may also implement the method of the invention by running suitable software code stored in the memory 10. It will be appreciated that such suitable software code can be conveyed to the controller on a machine readable medium such as a disk type media device or transmitted to the device 4 as a suitably encoded signal over a wireless link provisioned by the wireless communications network 2.

As is well known in the art, convolutionally encoded symbols are decoded using a Viterbi decoder 18 which may, for example, be implemented in a terminal device 4. If desired, the Viterbi decoder 18 may be implemented as part of the RF transceiver 8 as shown in FIG. 5, but this is not essential. In general, potential values of the data bits are latched into a shift register of length k-1, where k is the constraint length of the convolutional code. As each potential bit value is latched into the shift register, the corresponding state changes in the decoder are used to yield the expected channel symbols for comparison against the received symbols to determine the most likely state transitions that would have occurred in the encoder at the transmitter end of the link. This process is usually visualized using a trellis diagram. A representative trellis diagram, for the case of k=3, is shown in FIG. 2. The rows of the trellis correspond to states of the shift register, and the columns correspond to the data bits to be decided. Since each state can be reached from at least two prior states, this results in multiple paths being mapped through the trellis diagram. At the end of the message (or message block), a least cost (or highest probability) path of state changes through the trellis diagram is selected, and the original data recovered by means of a trace-back along the selected path through the trellis diagram.

Normally, the decoder is assumed to start at state 0 and is forcibly terminated, through the appending of k-1 tail bits, at state 0. This provides a convenient mechanism for converging both ends of the trellis so that a unique survivor path representing the most likely decode of the received symbols can be chosen.

In the case of rate adaptation between any two of the various coding schemes of the EDGE protocol, for example, the number and location(s) of padding bits within the data block are known, as is the value of each padding bit. With this information, it is possible to skip over decoding of the known padding bits, and constrain the start state and/or the end state of the decoder according to the known values of the padding bits to force the padding bits to be decoded to their known values and thereby improve accuracy of the decoding operation.

FIG. 3 illustrates a trellis diagram in which the start state of the decoder is constrained by the last k-1 bits of prepended padding bits. For example, consider a data block having a total length of N bits, including n prepended padding bits. In this case, the first n bits of the transmitted data block can be latched into the shift register of the Viterbi decoder at the receiving end without being decoded. This can be done because the first n bits are known padding bits. This results in the shift register containing bits corresponding to the last k-1 bits of padding data, and the next bit to be decided by the Viterbi decoder will be the first bit of "actual" data. By setting the start state of decoder to the last k-1 bits of the prepended padding data, which are already known, decoding can skip over the first S=n/R symbols (where R is the code rate of the convolutional encoder) and start with the immediately following symbol, which would be the first symbol that has influence from actual data in the convolutionally encoded block. Decoding can then continue in a conventional manner. With this arrangement, only the actual data bits contribute to the number of candidate paths through the trellis diagram, and any erroneous paths that would have been constructed by the incorrect decoding of any of the padding bits are automatically pruned in advance.

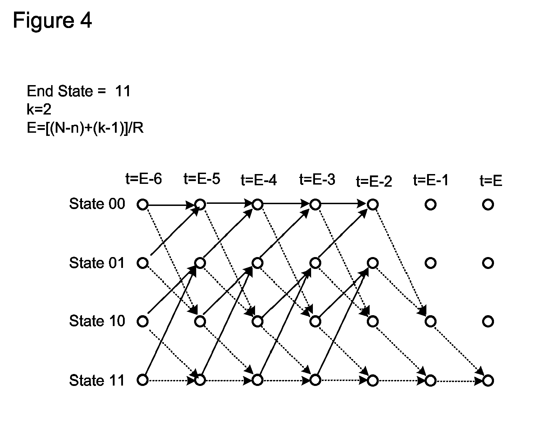

FIG. 4 illustrates a trellis diagram in which the end state is constrained by the first k-1 bits of appended padding bits. For example, consider a data block having a total length of N bits, including n appended padding bits. In this case, the first (N-n) bits are candidates for Viterbi decoding according to paths mapped through the trellis diagram from the processing of the first *e*=(*N-n*)+(*k-1*) received bits. To force a path to emerge as the most likely (least cost) decode, the trellis is made to converge on a known state dictated by the first k-1 bits of appended padding bits. This flushes all bits corresponding to "real" data out of the shift register, and leaves the shift register loaded with bits corresponding to the first k-1 padding bits. The remaining symbols of the encoded data block, all of which are determined only by padding bits, can be discarded without decoding. Traceback and decoding of the data bits can then proceed in a conventional manner, but starting from the known end state of the decoder as determined by the known first k-1 padding bits. With this arrangement, only the actual data bits contribute to the number of candidate paths through the trellis diagram, and any erroneous paths that would have been constructed by the incorrect decoding of any of the padding bits are automatically pruned in advance.

It will be appreciated that the methods described above with reference to FIGs. 3 and 4 can be combined for the case of a data block in which both prepended and appended padding bits are used for rate adaptation.

By constraining the decoder in the above-noted manner, the decoder only decodes bits corresponding to actual data. This improves decoder performance by minimizing the number of bits that need to be decoded in order to recover the data from a data block. In addition, decoding accuracy of the data is improved, because selection of the highest probability path for traceback and decoding is not perturbed by (possibly erroneously) decoded padding bits.

The conventional approach to using known data in Viterbi decoding involves trellis pruning to exclude non-candidate paths. However, implementation of a Viterbi decoder that supports arbitrary trellis pruning is complicated. The present technique is much more useful in practice because it is easy to implement a Viterbi decoder with selectable start and/or end states.

The embodiment(s) described above is(are) intended to be representative only. The scope of the present application is therefore intended to be limited solely by the scope of the appended claims.

## Claims

1. A method of decoding a convolutionally encoded data block having known padding bits, the method comprising steps of:
constraining a Viterbi decoder to a state corresponding to k-1 padding bits immediately adjacent data bits of the data block, where k is a constraint length of a convolutional encoder used to encode the data block; and
discarding symbols of the encoded data block that have influence only from the padding bits.

2. A method as claimed in claim 1, wherein at least a portion of the padding bits are prepended to the data bits, and wherein the step of constraining the Viterbi decoder comprises a step of constraining a Start state of the decoder to a state corresponding to the last k-1 padding bits prepending the data bits.

3. A method as claimed in claim 2, wherein the step of discarding symbols of the encoded data block comprises steps of:
latching the known padding bits of the data block into a shift register of the Viterbi decoder, without decoding the known padding bits; and
starting the Viterbi decoder at the first symbol after the first S=n/R symbols of the encoded data block, where n is the number of prepended padding bits, and R is the code rate of the convolutional encoder.

4. A method as claimed in claim 1, wherein at least a portion of the padding bits are appended to the data bits, and wherein the step of constraining the Viterbi decoder comprises a step of constraining an End state of the decoder to a state corresponding to the first k-1 padding bits appending the data bits.

5. A method as claimed in claim 4, wherein the step of discarding symbols of the encoded data block comprises steps of:
processing a sufficient number of symbols of the encoded data block through the Viterbi decoder to flush the bit corresponding to the last data bit out of the shift register; and
discarding any remaining symbols of the data block.

6. A method as claimed in claim 5, wherein the step of processing a sufficient number of symbols of the encoded data block through the Viterbi decoder comprises a step of processing the first *e*=(*N-n*)+(*k-1*) bits of the encoded data block through the Viterbi decoder, wherein N is the total number of bits capacity of the data block, and n is the total number of padding bits appended to the data bits.

7. A system for decoding a convolutionally encoded data block having known padding bits, the system comprising:
a Viterbi decoder; and
a controller adapted to:
constrain the Viterbi decoder to a state corresponding to k-1 padding bits immediately adjacent data bits of the data block, where k is a constraint length of a convolution encoder used to encode the data block; and
discard symbols of the encoded data block that have influence only from the padding bits.

8. A system as claimed in claim 7, wherein at least a portion of the padding bits are prepended to the data bits, and wherein the controller is adapted to constrain a start state of the decoder to a state corresponding to the last k-1 padding bits prepending the data bits.

9. A system as claimed in claim 8, wherein the controller is adapted to discard symbols of the encoded data block that have influence only from the padding bits by:
disabling operation of the Viterbi decoder while latching the known padding bits of the data block into a shift register of the Viterbi decoder; and
enabling the Viterbi decoder at the first symbol after the first S=n/R symbols of the encoded data block, where n is the number of prepended padding bits, and R is the code rate of the convolutional encoder.

10. A system as claimed in claim 7, wherein at least a portion of the padding bits are appended to the data bits, and wherein the controller is adapted to constrain an End state of the decoder to a state corresponding to the first k-1 padding bits appending the data bits.

11. A system as claimed in claim 10, wherein the controller is adapted to discard symbols of the encoded data block that have influence only from the padding bits by:
processing a sufficient number of symbols of the encoded data block through the Viterbi decoder to flush the bit corresponding to the last data bit out of the shift register; and
discarding any remaining symbols of the data block.

12. A system as claimed in claim 11, wherein processing a sufficient number of symbols of the encoded data block through the Viterbi decoder comprises processing the first *e*=(*N*-*n*)+(*k*-1) bits of the encoded data block through the Viterbi decoder, wherein N is the total number of bits capacity of the data block, and n is the total number of padding bits appended to the data bits.

13. A system as claimed in any one of claims 7 to 12, wherein the system comprises a wireless communications network subscriber terminal device.

14. A viterbi decoder for the system of any one of claims 7 to 13.

15. A computer program product for decoding a convolutionally encoded data block having known padding bits, the computer program product comprising a machine readable medium embodying software code for implementing in a computing device the method of any one of claims 1 to 6.

## Amended claims

### Amended claims in accordance with Rule 86(2) EPC.

**1.** A method of decoding a convolutionally encoded data block having a predetermined number of known padding bits, the method comprising steps of:
constraining a Viterbi decoder (18) to a state corresponding to k-1 padding bits immediately adjacent data bits of the data block, where k is a constraint length of a convolutional encoder used to encode the data block, and wherein the k-1 padding bits immediately adjacent data bits of the data block comprise less than the predetermined number of known padding bits; and
discarding symbols of the encoded data block that have influence only from padding bits other than the k-1 padding bits immediately adjacent data bits of the data block.

**2.** A method as claimed in claim 1, wherein at least a portion of the padding bits are prepended to the data bits, and wherein the step of constraining the Viterbi decoder (18) comprises a step of constraining a Start state of the decoder (18) to a state corresponding to the last k-1 padding bits prepending the data bits.

**3.** A method as claimed in claim 2, wherein the step of discarding symbols of the encoded data block comprises steps of:
disabling operation of the Viterbi decoder (18) while latching the known padding bits of the data block into a shift register of the Viterbi decoder (18); and
starting the Viterbi decoder (18) at the first symbol after the first S=n/R symbols of the encoded data block, where n is the number of prepended padding bits, and R is the code rate of the convolutional encoder.

**4.** A method as claimed in claim 1, wherein at least a portion of the padding bits are appended to the data bits, and wherein the step of constraining the Viterbi decoder (18) comprises a step of constraining an End state of the decoder to a state corresponding to the first k-1 padding bits appending the data bits.

**5.** A method as claimed in claim 4, wherein the step of discarding symbols of the encoded data block comprises steps of:
processing a sufficient number of symbols of the encoded data block through the Viterbi decoder (18) to flush the bit corresponding to the last data bit out of the shift register; and
discarding any remaining symbols of the data block.

**6.** A method as claimed in claim 5, wherein the step of processing a sufficient number of symbols of the encoded data block through the Viterbi decoder (18) comprises a step of processing the first *e* = (*N - n*) + (*k* - 1) bits of the encoded data block through the Viterbi decoder (18), wherein N is the total number of bits capacity of the data block, and n is the total number of padding bits appended to the data bits.

**7.** A method as claimed in claim 1, wherein the convolutionally encoded data block is a data block of an Enhanced Data for Global Evolution, EDGE, data frame.

**8.** A system for decoding a convolutionally encoded data block having a predetermined number of known padding bits, the system comprising:
a Viterbi decoder (18); and
a controller (106) adapted to:
constrain the Viterbi decoder (18) to a state corresponding to k-1 padding bits immediately adjacent data bits of the data block, where k is a constraint length of a convolution encoder used to encode the data block, and wherein the k-1 padding bits immediately adjacent data bits of the data block comprise less than the predetermined number of known padding bits; and
discard symbols of the encoded data block that have influence only from padding bits other than the k-1 padding bits immediately adjacent data bits of the data block.

**9.** A system as claimed in claim 8, wherein at least a portion of the padding bits are prepended to the data bits, and wherein the controller (106) is adapted to constraining a start state of the decoder to a state corresponding to the last k-1 padding bits prepending the data bits.

**10.** A system as claimed in claim 9, wherein the controller (106) is adapted to discard symbols of the encoded data block that have influence only from the padding bits by:
disabling operation of the Viterbi decoder (18) while latching the known padding bits of the data block into a shift register of the Viterbi decoder (18); and
enabling the Viterbi decoder (18) at the first symbol after the first S=n/R symbols of the encoded data block, where n is the number of prepended padding bits, and R is the code rate of the convolutional encoder.

**11.** A system as claimed in claim 8, wherein at least a portion of the padding bits are appended to the data bits, and wherein the controller (106) is adapted to constrain an End state of the decoder (18) to a state corresponding to the first k-1 padding bits appending the data bits.

**12.** A system as claimed in claim 11, wherein the controller (106) is adapted to discard symbols of the encoded data block that have influence only from the padding bits by:
processing a sufficient number of symbols of the encoded data block through the Viterbi decoder (18) to flush the bit corresponding to the last data bit out of the shift register; and
discarding any remaining symbols of the data block.

**13.** A system as claimed in claim 12, wherein processing a sufficient number of symbols of the encoded data block through the Viterbi decoder (18) comprises processing the first *e* = (*N - n*) + (*k -* 1) bits of the encoded data block through the Viterbi decoder (18), wherein N is the total number of bits capacity of the data block, and n is the total number of padding bits appended to the data bits.

**14.** A system as claimed in claim 8, wherein the convolutionally encoded data block is a data block of an Enhanced Data for Global Evolution, EDGE, data frame.

**15.** A terminal device (4) of a wireless communications network (102), the terminal device (4) comprising the system claimed in any one of claims 8-14.

**16.** A viterbi decoder for the system of any one of claims 8 to 15.

**17.** A computer program product for decoding a convolutionally encoded data block having known padding bits, the computer program product comprising a machine readable medium embodying software code for implementing in a computing device the method of any one of claims 1 to 7.
